# EUROPÄISCHE PATENTANMELDUNG

(11) **EP 1 085 787 A2**
(43) Veröffentlichungstag der Anmeldung: **21.03.2001**
(21) Anmeldenummer: 00119673.2
(22) Anmeldetag: 08.09.2000
(51) Int. Cl.: H05K 1/00, H05K 5/00

(54) **Gehäuse für elektrische oder elektronische Vorrichtungen mit integrierten Leiterbahnen**

(30) Priorität: 16.09.1999 DE 19944383
(71) Anmelder: Ticona GmbH, 65451 Kelsterbach (DE)
(72) Erfinder: Platz, Reinhold G., 64367 Mühltal (DE)

(57) **Zusammenfassung**

Gehäuse für elektrische oder elektronische Vorrichtungen oder Bauteile bestehen aus einem Formteil (1) aus thermoplastischem Kunststoff, das an ausgewählten Stellen auf seiner Oberfläche elektrische Leiterbahnen (5) mit an vorbestimmten Stellen angebrachten Kontaktstiften (3, 6) aufweist, wobei die Leiterbahnen (5) mit einer Schicht (8) aus thermoplastischem Kunststoff bedeckt sind. Vorzugsweise handelt es sich dabei um ein mehrschichtiges Formteil, wobei sich zwischen mindestens zwei Schichten Leiterbahnen befinden, auf die gegebenenfalls auch elektronische Bauteile wie Sensoren, Mikroschalter oder SMD-Bauteile aufgebracht sind, die wahlweise mit umspritzt werden.

## Beschreibung

Die vorliegende Erfindung betrifft ein Gehäuse für elektrische oder elektronische Vorrichtungen aus einem thermoplastischen Kunststoff, das integrierte Leiterbahnen, elektronische Bauteile und elektrische Kontakte enthält, sowie ein Verfahren zu seiner Herstellung. Die Leiterbahnen und elektronischen Bauteile werden dabei mit thermoplastischem Kunststoff versiegelt. Die vorliegende Anmeldung bezieht sich auf die Anmeldung DE 19944383.1.

Weitläufig bekannt sind Platinen für elektrische Schaltungen, die auf ihrer Oberfläche elektrische Leiterbahnen tragen, an die elektronische Bauteile wie Transistoren, Relais, Computerchips etc. angelötet sind. Die Platinen sind in der Regel aus einem elektrisch isolierenden duroplastischen Kunststoff gefertigt.

Bekannt sind auch Steckverbinder aus Kunststoff, die zu einer Seite Kontaktstifte oder Kontakthülsen aufweisen, die in den Kunststoff eingegossen oder eingesteckt sind. An der anderen (Rück-) Seite der Kontaktstifte oder Kontakthülsen sind elektrische Leitungen befestigt, die in der Regel zu einem Kabel zusammengeführt werden. Diese Steckverbinder enthalten jedoch keine elektrischen Leiterbahnen, die verschiedene der Kontaktstifte oder Kontakthülsen miteinander verbinden.

Bauteile für elektrische oder elektronische Vorrichtungen sind üblicherweise so aufgebaut, daß beispielsweise ein Elektromotor, eine elektrische Schaltung etc. von einem Gehäuse umgeben ist. Die elektrische Kontaktierung geschieht dabei meist durch ein Kabel, das durch eine Öffnung im Gehäuse hindurch geführt und direkt oder mit Hilfe eines Steckverbinders mit der elektrischen oder elektronischen Vorrichtungen verbunden wird.

Besonders in der Maschinen- und Fahrzeugtechnik gibt es eine Menge Beispiele für derartige Baugruppen: Verteilerboxen, Boxen für Sicherungen und Boxen für spezielle Fahrzeugelektronik, jeweils bestehend aus einem Gehäuse, einer Platine mit elektrischen Schaltungen und Bauteilen und einer separaten Stromzuführung, die durch eine Öffnung im Gehäuse geführt wird, sowie Gehäuse für Türschlösser, Fensterheber- oder Scheibenwischergetriebe, die u.a. einen Elektromotor und eine durch das Gehäuse geführte Stromzuleitung enthalten.
Ein Problem, das hierbei auftritt, ist oft ein ungenügender Schutz der elektrischen oder elektronischen Bauteile vor Feuchtigkeit, da die Kabeldurchführungen der Stromzuleitungen meist, oder wenn vorgesehen nicht dauerhaft paßgenau sind und eine separate Abdichtung nicht vorgenommen wird. Andererseits ist durch das Einfädeln der Stromzuführung, den Anschluß des Kabelendes der Stromzuführung an die im Inneren des Gehäuses befindliche und ggf. befestigte elektrische oder elektronische Vorrichtungen eine Vielzahl von Arbeitsschritten für die Montage nötig.

In der noch nicht veröffentlichten deutschen Patentanmeldung Nr. 199 378 65.7 werden Kunststofformteile beschrieben, die auf einer Seite auf ihrer Oberfläche elektrische Leiterbahnen aufweisen, in die Kontaktstifte eingebracht sind, wobei ein Teil dieser Kontaktstifte von der Oberfläche mit den elektrischen Leiterbahnen absteht und ein Teil der Kontaktstifte durch die Kunststoffschicht hindurch dringt und auf der anderen, entgegengesetzten Seite herausragt. Diese Kunststofformteile sind insbesondere als Gehäuse für elektrische oder elektronische Vorrichtungen und Bauteile vorgesehen. In ihnen liegen die elektrischen Leiterbahnen jedoch offen an der Oberfläche vor und können somit durch Feuchtigkeit oder Elektrolyte kurzgeschlossen werden.

Es bestand nun die Aufgabe, eine verbesserte Möglichkeit zur Fertigung elektrischer oder elektronischer Baugruppen zu finden, die möglichst auch eine einfache Montage ermöglicht.

Diese Aufgabe wird erfindungsgemäß dadurch gelöst, daß ein Kunststofformteil bereitgestellt wird, das elektrische Leiterbahnen, Kontaktstifte und wahlweise Steckverbindungen oder SMD-Bauteile enthält, wobei die Leiterbahnen mit einer isolierenden Kunststoffschicht bedeckt sind.

Die Erfindung betrifft daher ein Gehäuse für elektrische oder elektronische Vorrichtungen bestehend aus einem Formteil aus einem thermoplastischen Kunststoff, das an ausgewählten Stellen auf seiner Oberfläche elektrische Leiterbahnen enthält, in die an vorbestimmten Stellen Kontaktstifte oder Bohrungen zum Einbringen von Kontaktstiften eingebracht sind, wobei die Leiterbahnen mit einer Schicht aus einem thermoplastischen Kunststoff bedeckt sind.
In einer bevorzugten Ausführungsform besteht das erfindungsgemäße Gehäuse aus einem mehrschichtigen Formteil aus thermoplastischem Kunststoff, wobei das Formteil mindestens zwei Schichten aus thermoplastischem Kunststoff aufweist, zwischen denen sich elektrische Leiterbahnen und gegebenenfalls elektronische Bauteile befinden, in die an vorbestimmten Stellen Kontaktstifte oder Bohrungen zum Einbringen von Kontaktstiften eingebracht sind.

Die Erfindung betrifft auch Verfahren zur Herstellung des erfindungsgemäßen Gehäuses wie sie im Folgenden und in den Ansprüchen beschrieben sind.

Das erfindungsgemäße Formteil vereint die Funktionen eines Gehäuses und einer Platine. Seine Vorteile bestehen beispielsweise darin, daß das Gehäuse keine Öffnung zur Durchführung der Stromzuleitung benötigt und somit ein vollständiger Feuchtigkeitsausschluß im Inneren des Gehäuses, wo sich die Leiterbahnen und die elektrische oder elektronische Vorrichtung befindet, gewährleistet werden kann. Stromzuleitungen können zudem in einfacher Weise außen am Gehäuse auf durch herausragende Kontaktstifte gebildete Steckverbindungen aufgesteckt werden.

Im Inneren des Gehäuses können durch das Design der Leiterbahnen sowie zusätzlich durch Auf- oder Einstecken elektronischer Teile oder Baugruppen (z.B. Sensore, Mikroschalter, SMD-Bauteile) auf die Kontaktstifte bzw. in vorgefertigte Bohrungen eine elektronische Schaltung realisiert werden. Umfaßt das Gehäuse außer der elektronischen Schaltung elektrische Bauteile, beispielsweise einen Elektromotor, so kann der Kontakt zum elektrischen Bauteil auch durch eine separate Steckverbindung, d.h. mit einem Kabel und einem Stecker, der im Inneren des Gehäuses aufgesteckt wird, erfolgen, vorteilhafter jedoch wird das elektrische Bauteil selbst direkt auf die Kontaktstifte aufgesteckt. Insbesondere mit der letzten Variante können mehrere Arbeitsschritte eingespart werden. Zusätzlich können elektronische Bauteile direkt auf die Leiterbahnen geklebt oder aufgelötet werden, die dann ebenfalls durch die zweite Kunststoffschicht vollständig abgedeckt werden.

Das erfindungsgemäße Gehäuseformteil besteht aus mindestens einem thermoplastischen Kunststoff oder Kunststoff-Blend und kann wahlweise auch verstärkt sein. Bezüglich des thermoplastischen Kunststoffs zur Bedeckung der Leiterbahnen sowie bei mehrschichtigem Aufbau des Formteils können durchaus verschiedene Kunststoffe oder Kunststoff-Blends zum Einsatz kommen. Dabei ist darauf zu achten, daß Kunststoffe, die mit den Leiterbahnen und den Kontaktstiften in Kontakt kommen, elektrisch isolierend sind und daß benachbarte Schichten aus miteinander verträglichen Kunststoffmaterialien bestehen, die miteinander verschmelzen oder einen engen haftenden Verbund eingehen.

Für Anwendungen in der Maschinen- und Fahrzeugtechnik sind als Kunststoffe besonders Polyacetale, insbesondere Polyoxymethylenhomo- und Copolymere (POM), Polyester, insbesondere Polyethylenterephthalat (PET) und Polybutylenterephthalat (PBT), Polyarylenether und -sulfide, insbesondere Polyphenylenoxid (PPO) und -sulfid (PPS), Polyolefine, insbesondere hoch- und niedermolekulares Polyethylen (PE) und Polypropylen (PP), Polyamide (PA), Polycarbonate (PC), cycloolefinische Homo- und Copolymere (COC) sowie flüssigkristalline (LCP) Polymere bevorzugt. Bevorzugte Kunststoff-Blends sind schlagzähe Mischungen beispielsweise mit thermoplastischen Elastomeren oder Acrylnitril-Styrol-Blends, aber auch Mischungen der vorgenannten Kunststoffe untereinander oder mit anderen Komponenten.

Der thermoplastische Kunststoff bzw. das Blend kann übliche Additive und Zusatzstoffe wie Stabilisatoren, Antioxidantien, Flammschutzmittel etc. sowie Farbmittel, Füll- und Verstärkungsstoffe enthalten. Um eine besondere Festigkeit des Formteils zu gewährleisten kann es auch vorteilhaft sein, als Verstärkungsmittel neben anderen oder an Stelle anderer feiner Partikel mit einer mittleren Teilchenlänge < 0,5 mm, beispielsweise Kurzglasfasern, Partikel mit einer mittleren Teilchenlänge > 0,5 mm, insbesondere > 1 mm oder gar > 5 mm zu verwenden, beispielsweise langglasfaserverstärktes Polyacetal, Polyamid, Polyolefin oder Polyester. Insbesondere bei Zugabe von Ruß zur Schwarzfärbung des Formteils ist darauf zu achten, daß der Kunststoff nicht leitfähig wird und Kriechströme oder Kurzschlüsse verursacht.

Metallische Leiterbahnen können durch allgemein bekannte Verfahren wie Heißprägen und galvanische Techniken auf die Oberfläche des Kunststoffs aufgetragen, unter Verwendung neuerer Lasertechniken in bzw. auf die Oberfläche des Kunststoffs ein- bzw. aufgetragen oder in Form von Stanzgittern eingelegt werden. Dabei ist im Sinne der Einsparung von Arbeitsschritten bei der Fertigung des erfindungsgemäßen Gehäuseformteils die Verwendung von vorgefertigten Metallfolien besonders vorteilhaft.

Die Leiterbahnen können aber auch aus einem leitfähigen Kunststoff bestehen und beispielsweise im Spritzgußverfahren aufgetragen werden oder als vorgefertigte Einheit eingelegt und gegebenenfalls mittels Laser mit der Formteiloberfläche verschweißt werden. Leitfähige Kunststoffe können Leitfähigkeitsruß, leitfähigen Graphit sowie metallische Partikel, insbesondere Späne, Pulver oder Fasern, einzeln oder in Kombination enthalten. Aus dem gleichen Material können wahlweise auch Kontaktstellen gefertigt werden.

Die Leiterbahnen können, genauso wie das Gehäuseformteil, eine vorbestimmte dreidimensionale Gestalt einnehmen. Dabei können wahlweise auch Erhebungen und Vertiefungen sowie dickere und dünnere Stellen vorgesehen werden.

In die Leiterbahnen können an vorbestimmten Stellen Kontaktstifte eingebracht werden. Dies kann durch Einschießen oder Einstecken von metallischen Stiften geschehen. Kontaktstellen können aber auch nach anderen Methoden erzeugt werden, beispielsweise durch Aufspritzen oder Auflöten elektrisch leitfähiger Materialien. Wahlweise können aber auch durch Bohrungen, Stifte im Werkzeug etc. Öffnungen in den Leiterbahnen und der sie bedeckenden Kunststoffschicht vorgesehen werden, in die Kontaktstifte oder Bauteile eingesteckt werden können.

Kontaktstifte können wahlweise im Kunststoff stecken und mit einem Ende von der Leiterbahn abstehen oder durch die Kunststoffschicht hindurch treten und mit einem Ende auf der entgegengesetzten Seite aus dem Kunststoff herausragen, wobei das andere Ende des Kontaktstifts mit der Oberfläche der Leiterbahn abschließt oder zusätzlich auch von dieser absteht.

Das erfindungsgemäße Gehäuseformteil wird beispielsweise derart hergestellt, daß im Spritzgieß- oder Tiefziehverfahren ein Rohling geformt wird, auf den vorgefertigte Leiterbahnen gegebenenfalls zusammen mit Kontaktstiften oder elektronischen Bauteilen aufgebracht und anschließend mit einer zweiten Schicht aus thermoplastischem Kunststoff umspritzt und versiegelt werden. Auf diese Weise können gleichzeitig Stecker und Halteelemente mit gefertigt werden.

Die Kontaktstifte haben in der Regel eine einfache zylindrische oder viereckige Form. Zur Verbesserung des Kontakts mit der Leiterbahn ist es jedoch vorteilhaft, wenn die Kontaktstifte an der Stelle, mit der sie nach dem Einschießen mit der Leiterbahn in Kontakt stehen einen größeren Querschnitt aufweisen. Derartige Stifte sind weitläufig bekannt. Zur Verbesserung der Kontaktierung kann die Verbindung zwischen Kontaktstift und Leiterbahn mit einem Leitkleber oder, insbesondere bei glasfaserverstärkten Kunststoffen mit einem Lot bedeckt werden. Bei Kontaktstiften, die durch den Kunststoff hindurch treten wird durch das Verkleben oder Verlöten zudem verhindert, daß Feuchtigkeit durch das Loch, in dem der Kontaktstift steckt, hindurch diffundiert und in das Innere des Gehäuses gelangt.

Die Dicke der Leiterbahnen ist den speziellen Anforderungen einer Anwendung entsprechend auszuwählen. Üblich sind Dicken von 35 bis 100 µm. Insbesondere bei Verwendung vorgefertigter Leiterbahnsysteme können die Leiterbahnen bereits mit elektronischen Bauteilen wie Sensoren, Mikroschalter, SMD-Bauteile etc. bestückt und mit diesen verlötet oder verklebt werden. Diese Bauteile werden dann beim Abdecken der Leiterbahnen mit thermoplastischem Kunststoff ebenfalls mit umspritzt.

Das erfindungsgemäße Formteil findet beispielsweise als Türschloßgehäuse, als Gehäuse für Fensterheber- oder Scheibenwischergetriebe, in Form eines Türmoduls mit integrierten elektrischen Leitungen und Kontakten, für Tankgeber oder für Verteilerboxen Verwendung. Je nach Verwendung kann es dabei erforderlich sein, das Formteil zusätzlich mit einer Dichtung oder Befestigungselementen zu versehen. Dies geschieht vorteilhaft ebenfalls in einem Arbeitsgang mit der Herstellung des Formteils, beispielsweise im Mehrkomponentenspritzgußverfahren, kann aber auch in einem gesonderten Arbeitsschritt erfolgen.

Die folgenden Ausführungsbeispiele sollen die Erfindung für den Fachmann verdeutlichen ohne jedoch einen einschränkenden Charakter zu haben.

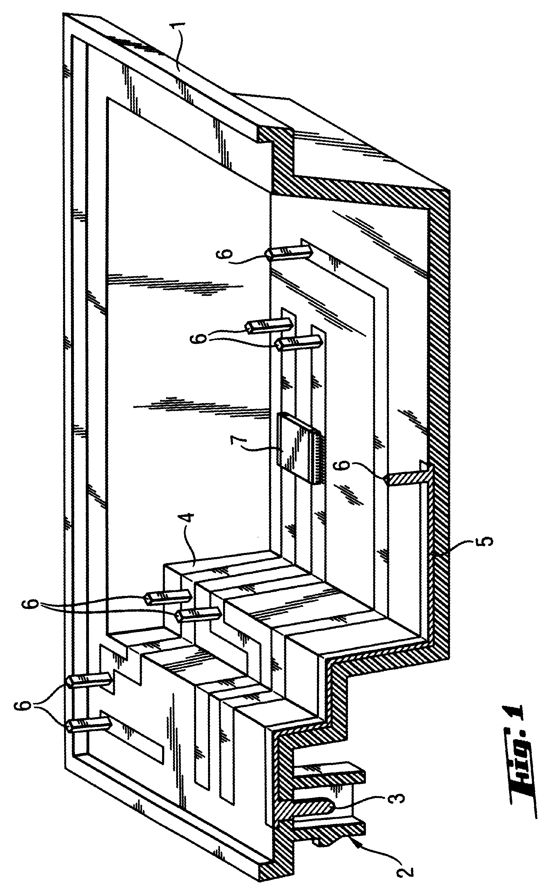

Figur 1 zeigt perspektivisch sowie im Querschnitt (vordere Ansicht) den dreidimensional gestalteten Rohling 1 eines Kunststoffgehäuses, der nach einer Seite hin eine integrierte Steckverbindung 2 mit Kontaktstiften 3 aufweist. Auf der anderen Seite 4 befinden sich Leiterbahnen 5, mit Kontaktstiften 6 und einer elektronischen Baugruppe 7.

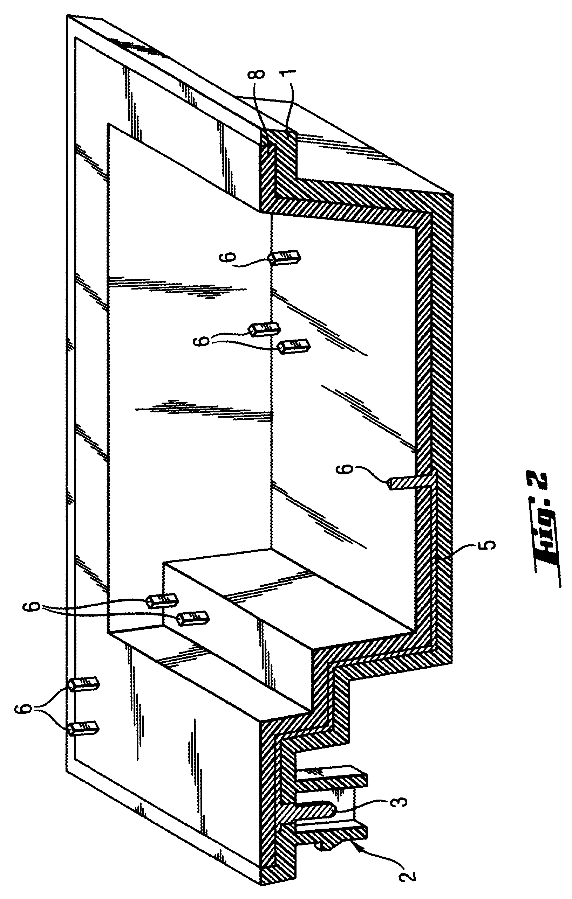

Figur 2 zeigt in der gleichen Ansicht als fertiges Kunststoffgehäuse den mit einer zusätzlichen Schicht 8 aus thermoplastischem Kunststoff überzogenen Rohling von Figur 1.

## Patentansprüche

1. Gehäuse für elektrische oder elektronische Vorrichtungen oder Bauteile aus einem Formteil (1) aus thermoplastischem Kunststoff, das an ausgewählten Stellen auf seiner Oberfläche elektrische Leiterbahnen (5) mit an vorbestimmten Stellen angebrachten Kontaktstiften (3, 6) aufweist, dadurch gekennzeichnet, daß es aus einem mehrschichtigen Formteil aus thermoplastischem Kunststoff besteht, wobei das Formteil mindestens zwei Schichten aus thermoplastischem Kunststoff aufweist, zwischen denen sich elektrische Leiterbahnen befinden, in die an vorbestimmten Stellen Kontaktstifte, eingebracht sind.

2. Gehäuse nach Anspruch 1, dadurch gekennzeichnet, daß als thermoplastischer Kunststoff Polyacetal, insbesondere Polyoxymethylenhomo- und/oder Copolymer, Polyester, insbesondere Potyethylenterephthalat oder Polybutylenterephthalat, Polyarylenether oder -sulfid, insbesondere Polyphenylenoxid oder -sulfid, Polyolefin, insbesondere hoch- oder niedermolekulares Polyethylen oder Polypropylen, Polyamid, Polycarbonat, cycloolefinisches Homo- oder Copolymer, flüssigkristallines Polymer oder eine Mischung davon eingesetzt wird.

3. Gehäuse nach einem der Ansprüche 1 oder 2, dadurch gekennzeichnet, daß der thermoplastische Kunststoff eine schlagzäh modifizierte Polymermischung, insbesondere eine Mischung mit mindestens einem thermoplastischen Elastomeren oder ein Acrylnitril-Styrol-Blend enthält.

4. Gehäuse nach einem der Ansprüche 1 bis 3, dadurch gekennzeichnet, daß der für das Formteil verwendete thermoplastische Kunststoff gleich dem thermoplastischem Kunststoff ist, mit dem die Leiterbahnen bedeckt sind.

5. Gehäuse nach einem der Ansprüche 1 bis 4, dadurch gekennzeichnet, daß der für das Formteil verwendete thermoplastische Kunststoff von dem thermoplastischem Kunststoff, mit dem die Leiterbahnen bedeckt sind, verschieden ist.

6. Gehäuse nach einem der Ansprüche 1 bis 5, dadurch gekennzeichnet, daß es zusätzlich mindestens eine integrierte Dichtung und/oder mindestens ein integriertes elektronisches Bauteil oder Befestigungselement enthält.

7. Gehäuse nach einem oder mehreren der Ansprüche 1 bis 7, wobei mindestens ein SMD-Bauteil mit einem oder mehreren der elektrischen Leiterbahnen elektrisch leitend verbunden ist und sich wie die Leiterbahnen zwischen zwei Schichten aus thermoplastischem Kunststoff befindet.

8. Baugruppe umfassend ein Gehäuse nach einem der vorstehenden Ansprüche sowie mindestens eine elektrische oder elektronische Vorrichtung.

9. Baugruppe nach Anspruch 7 oder 8, dadurch gekennzeichnet, daß die elektrische oder elektronische Vorrichtung ausgewählt ist aus Elektromotor- und Getriebeeinheiten und elektronischen Bauteilen.

10. Verfahren zur Herstellung eines Gehäuses für elektrische oder elektronische Vorrichtungen oder Bauteile bestehend aus einem Formteil mit mindestens zwei Schichten aus thermoplastischem Kunststoff zwischen denen sich elektrische Leiterbahnen befinden, in die an vorbestimmten Stellen Kontaktstifte eingebracht sind, wobei ein Formteil-Rohling geformt wird, Leiterbahnen auf den Rohling aufgetragen werden, Kontaktstifte, und wahlweise elektronische Bauteile mit den Leiterbahnen verbunden werden, und die Leiterbahnen mit einer Schicht aus einem thermoplastischem Kunststoff versiegelt werden.

11. Verfahren nach Anspruch 10, dadurch gekennzeichnet, daß die elektronischen Bauteile beim Versiegeln der Leiterbahnen ebenfalls mit thermoplastischem Kunststoff bedeckt werden.

12. Verfahren nach Anspruch 10 oder 11, dadurch gekennzeichnet, daß das Verfahren mindestens zwei Spritzgußschritte beinhaltet.

13. Verfahren nach einem oder mehreren der Ansprüche 10 bis 12, wobei die Kontaktstifte in vorgefertigte Löcher eingeschossen werden.

14. Verfahren nach einem oder mehreren der Ansprüche 10 bis 13, wobei die verwendeten elektronischen Bauteile mindestens ein SMD-Bauteil, mindestens einen Mikroschalter oder mindestens einen Sensor beinhalten.

15. Verfahren nach einem oder mehreren der Ansprüche 10 bis 14, wobei der Formteil-Rohling durch Tiefziehen hergestellt wird.

16. Verfahren nach einem oder mehreren der Ansprüche 10 bis 15, wobei die Leiterbahnen durch Heißprägen, durch ein galvanisches Verfahren, unter Verwendung von Laserstrahlung oder durch Spritzguß einer leitfähigen Kunststofformmasse auf den Formteil-Rohling aufgebracht werden.
